# EUROPEAN PATENT APPLICATION

(11) **EP 3 582 254 A1**
(43) Date of publication of application: **18.12.2019**
(21) Application number: 18199286.8
(22) Date of filing: 09.10.2018
(51) Int. Cl.: H01L 21/67, H01L 21/677, H01L 21/683

(54) **POSITIONING CONVEYANCE MECHANISM AND POSITIONING CONVEYANCE PRODUCTION SYSTEM**

(30) Priority: 12.06.2018 CN 201810599251
(71) Applicant: Beijing Juntai Innovation Technology Co., Ltd, 100176 Beijing (CN)
(72) Inventor: LI, Wenbo, Beijing, Beijing 100176 (CN); XU, Mingxian, Beijing, Beijing 100176 (CN)
(74) Representative: Roman, Alexis

(57) **Abstract**

The disclosure relates to a positioning conveyance mechanism and a positioning conveyance production system, and belongs to the field of conveyance production equipment. The main technical solution adopted is that the positioning conveyance mechanism comprises a conveyance device, the conveyance device comprising a conveyance part used for carrying and conveying an object; and positioning devices used for fixing the object conveyed to a preset position by the conveyance part. The positioning conveyance mechanism provided by the disclosure can accurately fix the object on a horizontal plane after conveying the object by a fixed distance, so as to realize accurate automatic production.

## Description

This application is based on the Chinese patent application with application number 201810599251.4 and application date of June 12, 2018, and claims the priority of the Chinese patent application, the entire contents of which are hereby incorporated by reference.

### Technical Field

The disclosure relates to the field of conveyance production equipment, in particular to a positioning conveyance mechanism and a positioning conveyance production system.

### Background Art

At present, in the production process of many products, it is necessary to use a conveyance mechanism for conveyance of product components, that is, to convey the product components to designated positions for assembly, special treatment and the like. Commonly, in the PVD equipment manufacturing process during production of high-efficiency heterojunction batteries, a carrier plate is conveyed to a designated position by using a conveyance mechanism, and then a silicon wafer is put into a groove of the carrier plate. Wherein it is necessary that the conveyance of the carrier plate is stopped at every predetermined distance, so that the silicon wafer can be put in the carrier plate. Since the conveyance mechanism conveys the carrier plate by means of friction through a belt, and the conveyance mechanism cannot achieve absolute horizontal conveyance. Therefore, a certain position deviation is likely to be occured when the carrier plate is conveyed to the designated position. So that a subsequent vision system cannot detect the characteristic points of the groove in the carrier plate, and a robot cannot place the silicon wafer into the groove or cannot meet the coincident accuracy requirement for silicon wafer putting, thereby increasing the activation of the equipment, reducing the production efficiency, and increasing the fragmentation rate.

### Summary of the Disclosure

A positioning conveyance mechanism according to the disclosure comprises:
a conveyance device comprising a conveyance part used for carrying and conveying an object;
and a plurality of positioning devices used for fixing the object conveyed to a preset position by the conveyance part.

The following technical measures can be adopted to realize the purpose of the present invention and solve relevant technical problems.

Preferably, according to the aforementioned positioning conveyance mechanism, each of the positioning devices comprises a first positioning clamping part, a second positioning clamping part and a driving device,
the first positioning clamping part is used for fixing the position of the object in a first direction, and the second positioning clamping part is used for fixing the position of the object in a second direction, and the driving devices are used for driving the first positioning clamping part and the second positioning clamping part to carry out clamping action,
wherein the first direction is the same as a conveyance direction of the conveyance part, and the second direction is perpendicular to the first direction.

Preferably, according to the aforementioned positioning conveyance mechanism, the first positioning clamping part comprises a first positioning clamping unit and a second positioning clamping unit,
wherein the first positioning clamping unit and the second positioning clamping unit are oppositely arranged when clamping the object;
and the second positioning clamping part comprises a third positioning clamping unit and a fourth positioning clamping unit,
wherein the third positioning clamping unit and the fourth positioning clamping unit are oppositely arranged when clamping the object.

Preferably, the aforementioned positioning conveyance mechanism further comprises support frames oppositely arranged,
and the positioning devices are arranged on the support frames.

Preferably, the aforementioned positioning conveyance mechanism comprises multiple groups of positioning devices, the positioning devices comprises a plurality of first positioning clamping part, a plurality of second positioning clamping part and a plurality of driving devices, a plurality of the first positioning clamping parts and a plurality of the second positioning clamping parts are arranged on the support frames at intervals in the first direction.

Preferably, according to the aforementioned positioning conveyance mechanism, the first positioning clamping part comprises a first positioning clamping unit and a second positioning clamping unit,
wherein the first positioning clamping unit and the second positioning clamping unit are oppositely arranged;
and the second positioning clamping part comprises a third positioning clamping unit and a fourth positioning clamping unit,
wherein the third positioning clamping unit and the fourth positioning clamping unit are oppositely arranged.

Preferably, according to the aforementioned positioning conveyance mechanism, the distance between two adjacent first positioning clamping units is the same as the distance of the conveying part conveying the object each time,
and/or the distance between two adjacent second positioning clamping units is the same as the distance of the conveying part conveying the object each time.

Preferably, according to the aforementioned positioning conveyance mechanism, the number of the second positioning clamping parts is less than or equal to the number of the first positioning clamping parts,
wherein one second positioning clamping part is capable of using for forming a group of the positioning device together with one or more adjacent first positioning clamping parts. Preferably, according to the aforementioned positioning conveyance mechanism, the driving devices comprise a plurality of first driving devices and a plurality of second driving devices,
wherein the first driving devices are used for driving the first positioning clamping units and the second driving devices are used for driving the second positioning clamping units. Preferably, according to the aforementioned positioning conveyance mechanism, the first positioning clamping unit comprises a first slider and a second slider, wherein the first slider is slidably connected with the support frames in the first direction, and the second slider is vertically and slidably connected with the first slider;
the first driving device comprises a first direction driving device body and a vertical direction driving device body, wherein the first direction driving device body is connected with the corresponding first slider for driving the first slider to reciprocate in the first direction, and the vertical direction driving device body is connected with the corresponding second slider for driving the second slider to reciprocate in the vertical direction;
wherein the second positioning clamping units have the same structure as the first positioning clamping units, and the connection structure with the first driving devices is the same as that of the first positioning clamping units.

Preferably, according to the aforementioned positioning conveyance mechanism, the third positioning clamping units comprises a third slider and a fourth slider, wherein the third slider is slidably connected with the support frames in the second direction, and the fourth slider is vertically and slidably connected with the third slider; each of the second driving devices comprises a second direction driving device body and a vertical direction driving device body, wherein the second direction driving device body is connected with the corresponding third slider for driving the third slider to reciprocate in the second direction, and the vertical direction driving device body is connected with the corresponding fourth slider for driving the fourth slider to reciprocate in the vertical direction;
wherein the fourth positioning clamping units have the same structure as the third positioning clamping units, and the connection structure with the second driving devices is the same as that of the third positioning clamping units;
or, the plurality of third positioning clamping units are connected together and are slidably connected with the conveyance device in the second direction, and the second driving devices drive the plurality of third positioning clamping units to reciprocate in the second direction,
wherein the plurality of fourth positioning clamping units are connected together and are slidably connected with the conveyance device in the second direction, and the second driving devices drive the plurality of fourth positioning clamping units to reciprocate in the second direction.

Preferably, according to the aforementioned positioning conveyance mechanism, each of the second slider is provided with a clamping claw in the form of a roller, and each of the fourth sliders is provided with a clamping claw in the form of a roller.

Preferably, the aforementioned positioning conveyance mechanism further comprises position sensors for detecting the position information of the object;
and a control device which controls the conveyance device according to the difference between the position information of the object detected by the position sensors and first preset position information stored in advance in the control device.

The invention further provides a positioning conveyance production system, comprising: the aforementioned positioning conveyance mechanism;
a conveyance device for components to be assembled, the conveyance device being used for conveying the components to be assembled;
and the object being provided with a second preset position for bearing the components to be assembled;
first position sensing devices for detecting the position information of the components to be assembled on the conveyance device for components to be assembled;
second position sensing devices for detecting the second preset position information;
and execution devices which place the components to be assembled at the second preset position according to the position information detected by the first position sensing devices and the second position sensing devices.

The following technical measures can also be adopted to further realize the purpose of the present disclosure and solve relevant technical problems.

Preferably, according to the aforementioned positioning conveyance production system, the conveyance device for components to be assembled is arranged above the conveyance part of the positioning conveyance mechanism;
or, the conveyance direction of the conveyance device for components to be assembled is perpendicular to the conveyance direction of the conveyance part of the positioning conveyance mechanism.

By means of the technical scheme, the positioning conveyance mechanism and the positioning conveyance production system at least have the following advantages:
in the technical scheme, the positioning conveyance mechanism is additionally provided with the positioning devices, after the conveyance device conveys the object to the preset position, the positioning devices can fix the object to make the object located in a precise position, so that when the object is assembled, processed or treated in subsequent steps, the position of the object at the positioning conveyance mechanism can be accurately found, thus facilitating accurate automatic production; for example, when the positioning conveyance mechanism is used in the PVD equipment manufacturing process during production of high-efficiency heterojunction batteries, the carrier plate can be accurately fixed by the positioning devices while the carrier plate is conveyed to the designated position, so that subsequent silicon wafer placement work can be more accurate, thus reducing the activation of the equipment, improving the production efficiency, and lowering the fragmentation rate.

The above description is only an overview of the technical scheme of the present invention. In order to have a clearer understanding of the technical means of the present invention and implement the invention in accordance with the contents of the description, the following detailed description will be given with reference to the preferred embodiment of the present invention in conjunction with the accompanying drawings.

### Brief Description of the Drawings

Fig. 1 is a first viewing angle structure view of a positioning conveyance mechanism according to an embodiment of the present disclosure;
Fig. 2 is a second viewing angle structure view of a positioning conveyance mechanism according to an embodiment of the present disclosure;
Fig. 3 is an enlarged structure view of a first positioning clamping unit connected with a frame according to an embodiment of the present disclosure;
Fig. 4 is an enlarged structure view of a third positioning clamping unit connected with a frame according to an embodiment of the present disclosure;
Fig. 5 is a structure view of a positioning conveyance production system according to an embodiment of the present disclosure;

### Detailed Description of the Disclosure

In order to further illustrate the technical means and efficacy of the present disclosure to achieve the intended purpose of the disclosure, the specific implementation, method, structure, features and efficacy of the positioning conveyance mechanism and the positioning conveyance production system according to the present disclosure will be described in detail below with reference to the drawings and preferred embodiments. In the following description, different "an embodiment" or "embodiment" may not necessarily refer to the same embodiment. In addition, a particular feature, structure, or characteristic in one or more embodiments may be combined in any suitable form.

### Embodiment 1

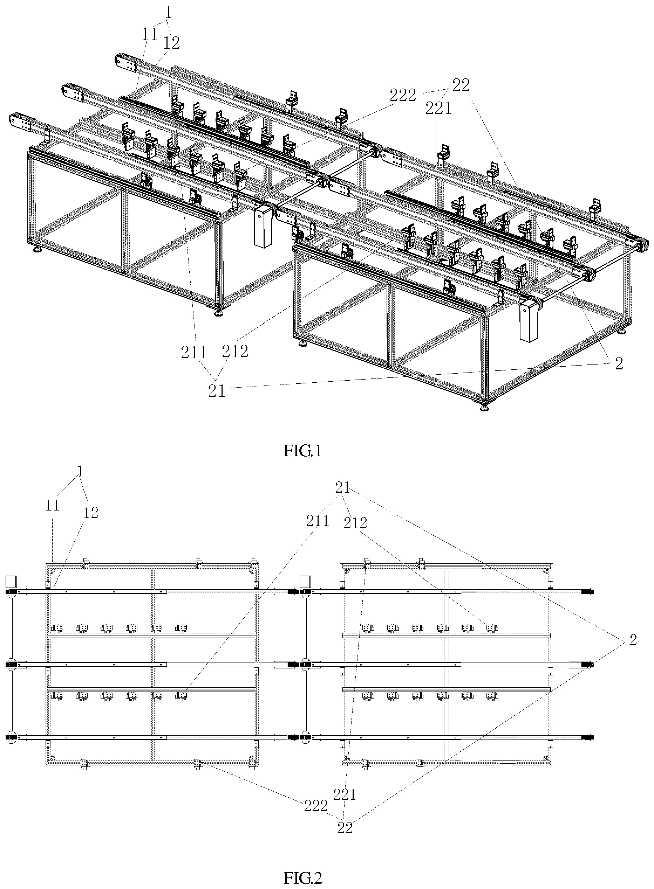

As shown in Fig. 1 and Fig. 2, a positioning conveyance mechanism provided in embodiment 1 of the disclosure comprises a conveyance device 1 and a plurality of positioning devices 2, wherein the conveyance device 1 comprises a conveyance part 12 used for carrying and conveying an object, and the positioning devices 2 are used for fixing the object conveyed to a preset position by the conveyance part 12.

Specifically, the conveyance device 1 may be a conveyance plate chain or a belt suitable for line production, or an object conveyor for single-process production, and the conveyance direction thereof can be horizontal or inclined. The conveyance device may comprise a support frame 11, the support frame 11 may be specifically set according to the load-bearing needs, for example, by steel riveting, bolting or welding; the support frame 11 can be specifically set according to the need of conveyance length; and the support frame 11 may be an integral structure or a split structure, for example, there are a plurality of support frames 11 connected side by side, and in the present embodiment, the support frames 11 preferably support the conveyance part 12.

The conveyance part 12 may be a horizontal conveyance belt or conveyance chain plate, or may be an inclined conveyance belt or conveyance chain plate; for a conveyance part 12 with a conveyance belt structure, the parallel number of conveyance belts and the width of each belt can be selected according to the specific production needs; similarly, for a conveyance part 12 with a chain plate structure, the parallel number of chain plates and the width of each chain plate can also be selected according to the production needs. In addition, the conveyance part 12 may conduct positioning conveyance, can be controlled by a servo motor, or realize position detection and feedback by means of position sensors so as to realize continuous fixed-distance conveyance, i.e., the conveyance part 12 may drive the object to travel the same distance or different distances each time, and the travel distance may be controlled by a host computer controlling production. The operation speed of the conveyance part 12 needs to be set specifically according to the actual production needs. The surface of the conveyance part 12 can also be treated according to the structural characteristics of the conveyed object, for example, adding a non-slip material layer. In the embodiment, a horizontal conveyance belt serves as the conveyance part 12 preferably and is arranged on the support frames 11.

The positioning devices 2 can be clamping and positioning devices which can fix one direction of the object or two directions of the object, for example, fix the conveyance direction of the object, or fix the conveyance direction as well as the direction perpendicular to the conveyance direction. As for specific positioning and clamping mechanisms of the positioning devices, a sliding clamping device driven by a driving device or a rotating clamping device driven by a driving device can be adopted, as long as the object can be accurately fixed. The positioning devices 2 may be arranged on the conveyance device 1, for example, on the support frames 11 of the conveyance device 1; or the positioning devices 2 may be separated from the conveyance device 1, for example, the positioning devices 2 may be disposed above the conveyance device 2, and when an object needs to be fixed, the positioning devices 2 move to a position where the object can be clamped and fixed.

In the technical solution, the positioning conveyance mechanism is additionally provided with the positioning devices, after the conveyance device conveys the object to the preset position, the positioning devices can fix the object to make the object located in a precise position, so that when the object is assembled, processed or treated in subsequent steps, the position of the object at the positioning conveyance mechanism can be accurately found, thus facilitating accurate automatic production; for example, when the positioning conveyance mechanism is used in the PVD equipment manufacturing process during production of high-efficiency heterojunction batteries, the carrier plate can be accurately fixed by the positioning devices while the carrier plate is conveyed to the designated position, so that subsequent silicon wafer placement work can be more accurate, thus reducing the activation of the equipment, improving the production efficiency, and lowering the fragmentation rate.

As shown in Fig. 1 and Fig. 2, in specific implementation, the positioning devices 2 comprises a plurality of first positioning clamping parts 21, a plurality of second positioning clamping parts 22 and a plurality of driving devices, the first positioning clamping parts 21 are used for fixing the position of the object in the first direction, the second positioning clamping parts 22 are used for fixing the position of the object in the second direction, and the driving devices are used for driving the first positioning clamping parts 21 and the second positioning clamping parts 22 to carry out clamping action, wherein the first direction is the same as the conveyance direction of the conveyance part 12, and the second direction is perpendicular to the first direction.

Specifically, each of the positioning devices 2 is composed of a first positioning clamping part 21 and a second positioning clamping part 22 with clamping directions perpendicular to each other, wherein the first positioning clamping part 21 may be any clamping structure controlled by the driving device to realize the positioning clamping action, for example, may be two clamping components controlled by the driving device, and the clamping components can slide relatively through the driving device, so as to clamp and fix the object on the horizontal conveyance part 12 in the conveyance direction; similarly, the second positioning clamping part 22 may be arranged with reference to the first positioning clamping part 21, but the second positioning clamping part 22 needs to clamp and fix the object in the second direction, wherein the second direction is perpendicular to the conveyance direction and the second direction is parallel to the plane where the conveyance part 12 is located; in this way, the object can be accurately fixed at a preset position through the first positioning clamping part 21 and the second positioning clamping part 22, namely the preset position to which the conveyance part 12 needs to convey the object, for example, when the conveyance part conducts horizontal conveyance, the first direction and the second direction are in the same horizontal plane. The number of the driving devices may be set according to the number of the positioning devices 2, or according to the number of the first positioning clamping parts 21 and second positioning clamping parts 22. The driving devices may be devices for driving the clamping parts to reciprocate, such as electric cylinders, air cylinders, hydraulic cylinders or driving motors. As shown in Fig. 1 and Fig. 2, in specific implementation, each of the first positioning clamping parts 21 comprises a first positioning clamping unit 211 and a second positioning clamping unit 212, wherein the first positioning clamping unit 211 and the second positioning clamping unit 212 are oppositely arranged when clamping the object; and each of the second positioning clamping parts 22 comprises a third positioning clamping unit 221 and a fourth positioning clamping unit 222, wherein the third positioning clamping unit 221 and the fourth positioning clamping unit 222 are oppositely arranged when clamping the object.

Specifically, each of the first positioning clamping parts 21 is a clamping device for positioning the conveyance direction of the object on the conveyance part 12, and may comprise two clamping units arranged opposite to each other, or clamping units capable of rotating and then clamping two opposite ends of the object. Similarly, each of the second positioning clamping parts 22 is a clamping device for positioning the second direction of the object on the conveyance part 12, and may comprise two clamping units arranged opposite to each other, or clamping units capable of rotating and then clamping two opposite ends of the object.

As shown in Fig. 1, in specific implementation, the positioning conveyance mechanism further comprises support frames 11 which are oppositely arranged, and the positioning devices 2 are arranged on the support frames 11.

Specifically, the support frames 11 may be any form of frame which can support the conveyance device 1 and can be used to fix the positioning devices 2, such as a frame made by steel welding or bolting.

As shown in Fig. 1 and Fig. 2, further, there are multiple groups of positioning devices 2, each group of positioning devices 2 comprises at least one first positioning clamping part 21 and at least one second positioning clamping part 22, that is, each of the positioning devices 2 comprises multiple first positioning clamping parts 21 and multiple second positioning clamping parts 22, wherein a plurality of the first positioning clamping parts 21 and a plurality of the second positioning clamping parts 22 are arranged on the support frames 11 at intervals in the first direction.

Specifically, the conveyance device 1 may be a device for fixed-distance conveyance of objects, i.e., the conveyance part 12 can stop after each step, so multiple groups of positioning devices 2 are arranged, the number of the groups needs to be the same as the number of steps of the conveyance device 1 for fixed-distance conveyance of objects, and each group of positioning devices 2 needs to be arranged corresponding to the position at which the conveyance part 12 stops during object conveyance, wherein the above-mentioned fixed-distance conveyance step refer to one step corresponding to one distance by which the object is conveyed by the conveyance device 1 in a fixed-distance conveyance manner. The first positioning clamping parts 21 and the second positioning clamping parts 22 need to be arranged on the support frames 11 of the conveyance device 1. The two positioning clamping parts have the same structure preferably, and can also be arranged according to the specific requirements when clamping objects.

As shown in Fig. 1 and Fig. 2, in specific implementation, each of the first positioning clamping parts 21 comprises a first positioning clamping unit 211 and a second positioning clamping unit 212, wherein the first positioning clamping unit 211 and the second positioning clamping unit 212 are oppositely arranged, and the distance between the first positioning clamping unit 211 and the second positioning clamping unit 212 corresponds to the length of the object in the first direction; and each of the second positioning clamping parts 22 comprises a third positioning clamping unit 221 and a fourth positioning clamping unit 222, wherein the third positioning clamping unit 221 and the fourth positioning clamping unit 222 are oppositely arranged, and the distance between the third positioning clamping unit 221 and the fourth positioning clamping unit 222 corresponds to the length of the object in the second direction.

Specifically, each of the first positioning clamping parts 21 is a clamping device for positioning the conveyance direction of the object on the conveyance part 12, and may comprise two oppositely disposed clamping units, i.e. by the relative movement of the first positioning clamping unit 211 and the second positioning clamping unit 212, the object can be clamped and positioned in the conveyance direction, the movement distance of the first positioning clamping unit 211 and the second positioning clamping unit 212 can be set according to actual needs, however, in order to ensure the minimum movement distance of the first positioning clamping unit 211 and the second positioning clamping unit 212 so as to improve the working efficiency, it is preferable to set the distance between the first positioning clamping unit 211 and the second positioning clamping unit 212 to correspond to the length of the object in the conveyance direction; the first positioning clamping unit 211 and the second positioning clamping unit 212 may slide relative to each other to clamp the object, or the object can be clamped and positioned after the two are rotated, for example, one end of the first positioning clamping unit 211 is connected with the driving device, the driving device drives the first positioning and clamping unit 211 to rotate so that the other end of the first positioning and clamping unit 211 bears against one side of the object; similarly, the arrangement of the second positioning clamping unit 212 is the same as that of the first positioning clamping unit 211, and the second positioning clamping unit 212 can bear against the other side of the object at one end after rotation, so as to realize clamping and positioning. The structure and arrangement of the second positioning clamping part 22 and the first positioning clamping part 21 may be the same, but the distance between the third positioning clamping unit 221 and the fourth positioning clamping unit 222 of the second positioning clamping part 22 needs to correspond to the length of the object in the second direction. In addition, the manner in which the third positioning clamping unit 221 and the fourth positioning clamping unit 222 position and clamp the object can be set with reference to the first positioning clamping unit 211 and the second positioning clamping unit 212, and will not be described here.

Besides, the number of the first positioning clamping units 211 of the first positioning clamping part 21 in each group of positioning devices 2 may be one or more, for example, two, depending on the length of the clamped object in the second direction, and the first positioning clamping units 211 are preferably arranged in a vacant position of the horizontal conveyance part 12. Similarly, the number of the second positioning clamping units 212 may be one or more, for example, two, and each of the second positioning clamping units 212 is opposite to the first positioning clamping unit 211 in the same group. Further, due to the distribution of the first positioning clamping part 21 and the second positioning clamping part 22 of each of the plurality of groups of positioning devices 2, the characteristics of the fixed-distance conveyance step of the conveyance device 1 need to be satisfied, and the first positioning clamping part 21 is located in the conveyance direction of the conveyance part 12, i.e., the distance between two adjacent first positioning clamping units 211 needs to be the same as the distance corresponding to the fixed-distance conveyance step; meanwhile, the distance between two adjacent second positioning clamping units 212 also needs be the same as the distance corresponding to the fixed-distance conveyance step. However, since the second positioning clamping parts 22 are perpendicular to the conveyance direction of the conveyance part 12, that is, at both sides of the conveyance part 12, the number of the second positioning clamping parts 22 may be less than or equal to the number of the first positioning clamping parts 21; wherein one of the second positioning clamping parts 22 can be used for forming a group of the positioning device 2 together with one or more adjacent first positioning clamping parts 21, in this way, the distance between two adjacent third positioning clamping units 221 may be equal to the distance corresponding to the fixed-distance conveyance step, or equal to 1/5-1/2 of the length of the object in the first direction; and the distance between two adjacent fourth positioning clamping units 222 may be equal to the distance corresponding to the fixed-distance conveyance step, or equal to 1/5-1/2 of the length of the object in the first direction.

As shown in Fig. 1 and Fig. 2, in specific implementation, each of the first positioning clamping parts 21 needs to be correspondingly provided with driving devices (not shown), and the driving devices preferably include a first driving device and a second driving device, wherein the number of the first driving devices is the same as the number of the first positioning clamping units 211, the first driving devices are used for driving the first positioning clamping units 211, the number of the second driving devices is the same as the number of the second positioning clamping units 212, and the second driving devices are used for driving the second positioning clamping units 212.

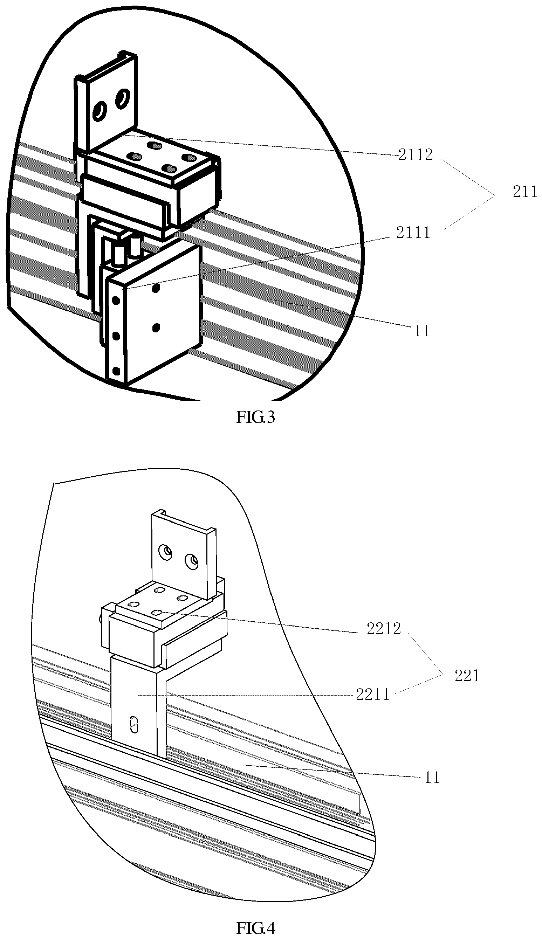

As shown in Fig. 1 to Fig. 4, further, each of the first positioning clamping units 211 comprises a first slider 2111 and a second 2112, wherein the first slider 2111 is slidably connected with the support frames 11 in the first direction, and the second slider 2112 is vertically and slidably connected with the first slider 2111; each of the first driving devices comprises a first direction driving device body and a vertical direction driving device body, wherein the first direction driving device body is connected with the corresponding first slider 2111 for driving the first slider 2111 to reciprocate in the first direction, and the vertical direction driving device body is connected with the corresponding second slider 2112 for driving the second slider 2112 to reciprocate in the vertical direction; wherein the second positioning clamping units 212 have the same structure as the first positioning clamping units 211, and the connection structure with the first driving devices is the same as that of the first positioning clamping units.

In addition, it is preferable that the first positioning clamping units 211 and the second positioning clamping units 212 are disposed below the surface, for conveying objects, of the conveyance part 12, in this way, when the conveyance part 12 conveys the object by one step in a fixed-distance conveyance manner and the first positioning clamping part 21 at a corresponding position is needed to clamp and position the object on the conveyance part 12 in the first direction, the two vertical driving device bodies drive the two second sliders 2112 of the first positioning clamping unit 211 and the second positioning clamping unit 212 respectively, the two second sliders 2112 are moved upward to a position at the same height as the object, then the two first direction driving device bodies drive the two first sliders 2111 of the first positioning clamping unit 211 and the second positioning clamping unit 212 respectively, so as to make the two first sliders move simultaneously and relatively and finally clamp the object, realizing the positioning of the object in the first direction after fixed-distance movement.

Further, the arrangement of the third positioning clamping units 221 and the fourth positioning clamping units 222 may refer to the first positioning clamping units 211, that is, each of the third positioning clamping units 221 may comprise a third slider 2211 and a fourth slider 2212, wherein the third slider 2211 is slidingly connected with the support frames 11 of the conveyance device 1 in the second direction, and the fourth slider 2212 is vertically and slidingly connected with the third slider 2211; each of the second driving devices comprises a second direction driving device body and a vertical direction driving device body, wherein the second direction driving device body is connected with the corresponding third slider 2211 for driving the third slider 2211 to reciprocate in the second direction, and the vertical direction driving device body is connected with the corresponding fourth slider 2212 for driving the fourth slider 2212 to reciprocate in the vertical direction; wherein the fourth positioning clamping units 222 have the same structure as the third positioning clamping units 221, and the connection structure with the second driving devices is the same as that of the third positioning clamping units. Specifically, the third positioning clamping units 221 and the fourth positioning clamping units 222 are preferably arranged on two sides of the conveyance part 12, i.e., the two sides perpendicular to the conveyance direction, in this way, when the conveyance part 12 conveys the object by one step in a fixed-distance conveyance manner and the second positioning clamping part 22 at a corresponding position is needed to clamp and position the object on the conveyance part 12 in the second direction, the two vertical driving device bodies drive the two fourth sliders 2212 of the third positioning clamping unit 221 and the fourth positioning clamping unit 222 respectively, the two fourth sliders 2212 are moved upward to a position at the same height as the object, then the two second direction driving device bodies drive the two third sliders 2211 of the third positioning clamping unit 221 and the fourth positioning clamping unit 222 respectively, so as to make the two third sliders move simultaneously and relatively and finally clamp the object, realizing the positioning of the object in the second direction after fixed-distance movement. Furthermore, since the third positioning clamping units 221 and the fourth positioning clamping units 222 are clamped on two sides of the movement direction of the object, the third positioning clamping units 221 and the fourth positioning clamping units 222 may not need to be arranged corresponding to the distance of fixed-distance conveyance of the object, as long as it is possible to clamp the object in the second direction; as a result, the third positioning clamping unit 221 may be of a connected structure, for example, a clamping plate or a clamping strip, and the fourth positioning clamping unit 222 can also be a connected structure which can be the same as the structure of the third positioning clamping unit 221 and can be a clamping plate or a clamping strip with a long length, so that no matter how many steps the object is conveyed in a fixed-distance conveyance manner on the conveyance part 12, the object can be clamped by the third positioning clamping unit 221 and the fourth positioning clamping unit 222, i.e., without considering the movement distance of the object, as long as the third positioning clamping unit 221 and the fourth positioning clamping unit 222 can position and clamp the object after the object is moved by a certain distance; at this time, the plurality of third positioning clamping units 221 are connected together, the plurality of fourth positioning clamping units 222 are connected together and are slidably connected with the support frames 11 in the second direction, the second driving devices drive the plurality of third positioning clamping units 221 to reciprocate in the second direction, and the second driving devices drive the plurality of fourth positioning clamping units 222 to reciprocate in the second direction.

In specific implementation, each of the second sliders is provided with a clamping claw in the form of a roller, and each of the fourth sliders is provided with a clamping claw in the form of a roller.

Specifically, the second sliders and the fourth sliders are both components which make direct contact with the object when the object is clamped and positioned, so the two are arranged in the form of rollers, which can prevent the edge of the object from being damaged and play a guiding role in the clamping process. In addition, in order to further prevent the second sliders and the fourth sliders from damaging the object while clamping the object, elastic rubber materials may be arranged on the surfaces of the second sliders and the fourth sliders.

In specific implementation, the positioning conveyance mechanism provided by the disclosure further comprises position sensors for detecting the position information of the object; and a control device which controls the conveyance device according to the difference between the position information of the object detected by the position sensors and first preset position information stored in advance in the control device.

Specifically, the position sensors can be arranged on the support frames at intervals in the first direction, and each position controller is correspondingly arranged at the position where the object is to be stopped in each fixed-distance conveyance step, i.e., the preset conveyance position of the object; and the control device may be a control computer or microcontroller arranged outside the positioning conveyance mechanism, or a control host arranged on the positioning conveyance mechanism, or may be a control system for controlling production on the production line.

### Embodiment 2

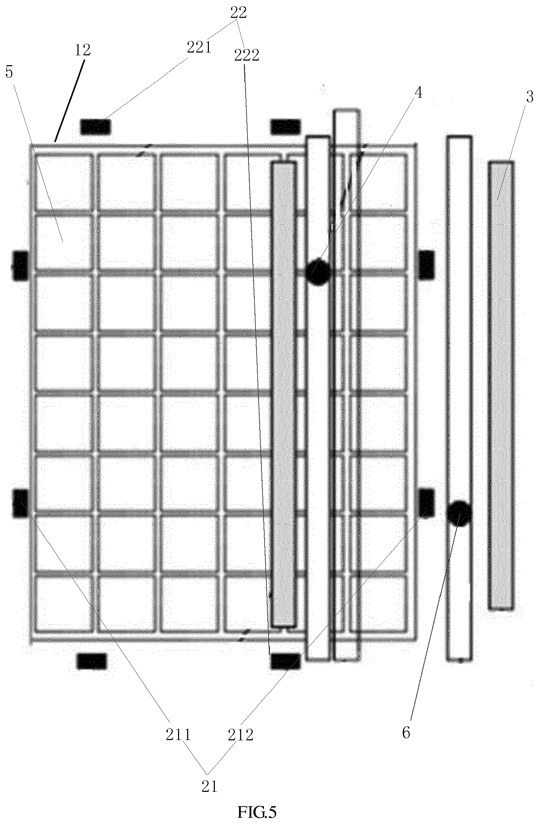

A positioning conveyance production system according to embodiment 2 of the present disclosure comprises a positioning conveyance mechanism; as shown in Fig. 1 and Fig. 2, the positioning conveyance mechanism comprises a conveyance device 1 and positioning devices 2, wherein the conveyance device 1 comprises a conveyance part 12 used for carrying and conveying an object, and the positioning devices 2 are used for fixing the object conveyed to a preset position by the conveyance part 12. As shown in Fig. 5, the positioning conveyance production system further comprises a conveyance device for components to be assembled 3, wherein the conveyance device for components to be assembled 3 is arranged above the conveyance part 12 of the positioning conveyance mechanism and used for conveying the components to be assembled, and the object 5 is provided with a second preset position for bearing the components to be assembled; first position sensing devices 4, for detecting the position information of the components to be assembled on the conveyance device for components to be assembled 3; second position sensing devices 6, for detecting the second preset position information, i.e., the preset position of the components to be assembled of the object 5 on the conveyance part 12; and execution devices (not shown) which receive position signals sent by the first position sensing devices 4 and the second position sensing devices 6, and place the components to be assembled in the second preset position of the object 5, namely the installation position of the components to be assembled.

Specifically, the positioning conveyance mechanism provided in embodiment 1 above can directly serve as the positioning conveyance mechanism described in embodiment 2, and the specific implementation structure can be found in the related contents described in embodiment 1 above and will not be described here. The first position sensing devices and the second position sensing devices can both be visual sensors.

As shown in Fig. 5, the positioning conveyance mechanism can be used for positioning conveyance of an object and fix the object after positioning conveyance so that the object is in an accurately positioned state. The conveyance device for components to be assembled 3 may be the same device as the conveyance device 1 in the positioning conveyance mechanism. In addition, the conveyance device for components to be assembled 3 is preferably a conveyance device for conveying objects in a plane so that the execution devices can grasp the components to be assembled easily. The number of the first position sensing devices 4 and the second position sensing devices 6 can be determined according to the area of the components to be assembled on the conveyance device 1 and the area of the object 5 on the positioning conveyance mechanism. The first position sensing devices 4 and the second position sensing devices 6 are used to detect the position of the components to be assembled on the conveyance device for components to be assembled 3 and the installation position of the components to be assembled of the object on the conveyance part 12, and at the same time, transmit detection results to a control center, a controller or directly to the execution devices. The execution devices may be multi-axis robots commonly used in industries, may be controlled by the control device of the positioning conveyance production system, or may be separately provided with a control device, such as a microcontroller. The execution devices may directly receive the detection signals from the visual sensing devices, or receive the detection signals processed by the controller from the position sensing devices, grasp the components to be assembled on the conveyance device for components to be assembled according to the information of the detection signals, and then install the components to be assembled on the object on the horizontal conveyance part, so as to complete the assembly and placement work.

In the technical solution, the positioning conveyance mechanism is additionally provided with the positioning devices, after the conveyance device conveys the object to the preset position, the positioning devices can fix the object to make the object located in a precise position, so that when the object is assembled, processed or treated in subsequent steps, the position of the object at the positioning conveyance mechanism can be accurately found, thus facilitating accurate automatic production; for example, when the positioning conveyance mechanism is used in the PVD equipment manufacturing process during production of high-efficiency heterojunction batteries, the carrier plate can be accurately fixed by the positioning devices while the carrier plate is conveyed to the designated position, so that subsequent silicon wafer placement work can be more accurate, thus reducing the activation of the equipment, improving the production efficiency, and lowering the fragmentation rate.

As shown in Fig. 5, in specific implementation, the conveyance direction of the conveyance device for components to be assembled 3 is perpendicular to the conveyance direction of the conveyance part 12. The number of the execution devices is two, and the two execution devices are oppositely arranged on both sides of the conveyance device of the positioning conveyance mechanism.

Specifically, since the conveyance device for components to be assembled is arranged above the conveyance device of the positioning conveyance mechanism, in order to facilitate the mounting of the components to be assembled on the object on the conveyance part, it is preferable to make the conveyance device for components to be assembled occupy as little space above the conveyance device as possible, so the best way is to make the conveyance direction of the conveyance device for components to be assembled perpendicular to the conveyance direction of the conveyance part. In addition, the number of the execution devices only needs to meet the installation and production work, too many execution devices will cause waste and increase the production cost, therefore, it is better to provide two execution devices and arrange the two execution devices opposite to each other.

The above is only the preferred embodiments of the present disclosure and is not intended to limit the present disclosure in any form. Any simple modifications, equivalent changes and modifications to the above embodiments according to the technical essence of the present disclosure still fall within the scope of the technical solution of the present disclosure.

## Claims

1. A positioning conveyance mechanism, comprising:
a conveyance device (1) comprising a conveyance part (12) used for carrying and conveying an object;
and a plurality of positioning devices (2) used for fixing the object conveyed to a preset position by the conveyance part (12).

2. The positioning conveyance mechanism according to claim 1, wherein
each of the positioning devices (2) comprises a first positioning clamping part (21), a second positioning clamping part (22) and a driving device,
the first positioning clamping part (21) is used for fixing the position of the object in a first direction, and the second positioning clamping part (22) is used for fixing the position of the object in a second direction, and the driving devices are used for driving the first positioning clamping part (21) and the second positioning clamping part (22) to carry out clamping action,
wherein the first direction is the same as a conveyance direction of the conveyance part (12), and the second direction is perpendicular to the first direction.

3. The positioning conveyance mechanism according to claim 2, wherein
the first positioning clamping part (21) comprises a first positioning clamping unit (211) and a second positioning clamping unit (212),
wherein the first positioning clamping unit (211) and the second positioning clamping unit (212) are oppositely arranged when clamping the object;
and the second positioning clamping part (22) comprises a third positioning clamping unit (221) and a fourth positioning clamping unit (222),
wherein the third positioning clamping unit (221) and the fourth positioning clamping unit (222) are oppositely arranged when clamping the object.

4. The positioning conveyance mechanism according to claim 2, wherein
the positioning conveyance mechanism further comprises support frames (11) oppositely arranged,
and the positioning devices (2) are arranged on the support frames (11).

5. The positioning conveyance mechanism according to claim 4, comprising multiple groups of positioning devices (2), the positioning devices (2) comprises a plurality of first positioning clamping part (21), a plurality of second positioning clamping part (22) and a plurality of driving devices, a plurality of the first positioning clamping parts (21) and a plurality of the second positioning clamping parts (22) are arranged on the support frames (11) at intervals in the first direction.

6. The positioning conveyance mechanism according to claim 5, wherein
the first positioning clamping part (21) comprises a first positioning clamping unit (211) and a second positioning clamping unit (212),
wherein the first positioning clamping unit (211) and the second positioning clamping unit (212) are oppositely arranged;
and the second positioning clamping part (22) comprises a third positioning clamping unit (221) and a fourth positioning clamping unit (222),
wherein the third positioning clamping unit (221) and the fourth positioning clamping unit (222) are oppositely arranged.

7. The positioning conveyance mechanism according to claim 6, wherein
the distance between two adjacent first positioning clamping units (211) is the same as the distance of the conveying part conveying the object each time,
and/or the distance between two adjacent second positioning clamping units (212) is the same as the distance of the conveying part (12) conveying the object each time.

8. The positioning conveyance mechanism according to claim 5, wherein
the number of the second positioning clamping parts (22) is less than or equal to the number of the first positioning clamping parts (21),
wherein one second positioning clamping part (22) is capable of using for forming a group of the positioning device together with one or more adjacent first positioning clamping parts (21).

9. The positioning conveyance mechanism according to claim 6, wherein
the driving devices comprise a plurality of first driving devices and a plurality of second driving devices,
wherein the first driving devices are used for driving the first positioning clamping units (211) and the second driving devices are used for driving the second positioning clamping units (212).

10. The positioning conveyance mechanism according to claim 9, wherein
the first positioning clamping unit (211) comprises a first slider (2111) and a second slider (2112), wherein the first slider (2111) is slidably connected with the support frames (11) in the first direction, and the second slider (2112) is vertically and slidably connected with the first slider (2111);
the first driving device comprises a first direction driving device body and a vertical direction driving device body, wherein the first direction driving device body is connected with the corresponding first slider (2111) for driving the first slider (2111) to reciprocate in the first direction, and the vertical direction driving device body is connected with the corresponding second slider (2112) for driving the second slider (2112) to reciprocate in the vertical direction;
wherein the second positioning clamping units (212) have the same structure as the first positioning clamping units (211), and the connection structure with the first driving devices is the same as that of the first positioning clamping units (211).

11. The positioning conveyance mechanism according to claim 9, wherein
the third positioning clamping unit (221) comprises a third slider (2211) and a fourth slider (2212), wherein the third slider (2211) is slidably connected with the support frames (11) in the second direction, and the fourth slider (2212) is vertically and slidably connected with the third slider (2211); each of the second driving devices comprises a second direction driving device body and a vertical direction driving device body, wherein the second direction driving device body is connected with the corresponding third slider (2211) for driving the third slider (2211) to reciprocate in the second direction, and the vertical direction driving device body is connected with the corresponding fourth slider (2212) for driving the fourth slider (2212) to reciprocate in the vertical direction;
wherein the fourth positioning clamping units (222) have the same structure as the third positioning clamping units (221), and the connection structure with the second driving devices is the same as that of the third positioning clamping units (221);
or, the plurality of third positioning clamping units (221) are connected together and are slidably connected with the conveyance device (1) in the second direction, and the second driving devices drive the plurality of third positioning clamping units (221) to reciprocate in the second direction,
wherein the plurality of fourth positioning clamping units (222) are connected together and are slidably connected with the conveyance device (1) in the second direction, and the second driving devices drive the plurality of fourth positioning clamping units (222) to reciprocate in the second direction.

12. The positioning conveyance mechanism according to claim 10 or 11, wherein
each of the second slider (2112) is provided with a clamping claw in the form of a roller, and each of the fourth sliders (2212) is provided with a clamping claw in the form of a roller.

13. The positioning conveyance mechanism according to claim 1, further comprising position sensors for detecting the position information of the object;
and a control device which controls the conveyance device (1) according to the difference between the position information of the object detected by the position sensors and first preset position information stored in advance in the control device.

14. A positioning conveyance production system, comprising:
the positioning conveyance mechanism according to claim 1-13;
a conveyance device (1) for components to be assembled, the conveyance device (1) being used for conveying the components to be assembled;
and the object being provided with a second preset position for bearing the components to be assembled;
first position sensing devices (4) for detecting the position information of the components to be assembled on the conveyance device (1) for components to be assembled;
second position sensing devices (6) for detecting the second preset position information;
and execution devices which place the components to be assembled at the second preset position according to the position information detected by the first position sensing devices (4) and the second position sensing devices (6).

15. The positioning conveyance production system according to claim 14, wherein
the conveyance device (1) for components to be assembled is arranged above the conveyance part (12) of the positioning conveyance mechanism;
or, the conveyance direction of the conveyance device (1) for components to be assembled is perpendicular to the conveyance direction of the conveyance part (12) of the positioning conveyance mechanism.
